# FASCICULE DE BREVET EUROPEEN

(11) **EP 3 005 555 B1**
(45) Date de publication et mention de la délivrance du brevet: **19.04.2017**
(21) Numéro de dépôt: 14727822.0
(22) Date de dépôt: 03.06.2014
(51) Int. Cl.: H03F 3/217, H03F 3/193

(54) **GENERATEUR DE HAUTE FREQUENCE**
HOCHFREQUENZGENERATOR
HIGH-FREQUENCY GENERATOR

(30) Priorité: 06.06.2013 FR 1355187
(43) Date de publication de la demande: 13.04.2016
(73) Titulaire: Commissariat à l'Énergie Atomique et aux Énergies Alternatives, 75015 Paris (FR)
(72) Inventeur: THOMAS, Thierry, F-38760 Varces Allieres et Risset (FR); JOSSELIN, Vincent, F-38000 Grenoble (FR)
(74) Mandataire: Priori, Enrico
(86) Numéro de dépôt international: PCT/EP2014/061435
(87) Numéro de publication internationale: WO 2014/195285

(56) Documents cités:
- US-A1- 2011 140 784
- MINCHEOL SEO ET AL: "A 13.56 MHz high-efficiency current mode class-D amplifier using a transmission-line transformer and harmonic filter", MICROWAVE CONFERENCE PROCEEDINGS (APMC), 2011 ASIA-PACIFIC, IEEE, 5 décembre 2011 (2011-12-05), pages 1262-1265, XP032152873, ISBN: 978-1-4577-2034-5 cité dans la demande

## Description

L'invention concerne les générateurs de hautes fréquences, et plus particulièrement l'étage de puissance en sortie du générateur.

Bien que l'invention soit applicable à une variété de contextes et de fréquences à produire, on la décrira à propos d'une application à un lecteur d'un système d'identification par étiquettes RFID (de l'anglais "Radio Frequency Identification"). Dans une telle application, le lecteur comprend un générateur de signaux qui, connecté ou associé à une antenne, permet de produire des signaux électromagnétiques radiofréquence, par exemple dans la gamme de 3 à 30 MHz ; ces signaux portent une information, et sont captés par une étiquette dite étiquette RFID qui recueille ces signaux, les reconnaît comme constituant une interrogation, et entraîne une réponse elle-même captée par le lecteur. La réponse peut consister en une modification des propriétés électromagnétiques de l'étiquette, cette modification agissant comme une variation de charge de l'antenne du lecteur, variation qui est reconnue et décodée par le lecteur. Le signal fourni par le lecteur peut parfois constituer aussi une source d'énergie captée par l'étiquette RFID lorsque celle-ci n'en possède pas.

Une fréquence typique de fonctionnement de ces systèmes est par exemple 13,56 MHz pour certaines normes en vigueur. Les puissances d'émission peuvent varier de 100 milliwatts (ou même moins) à 10 watts (ou même plus) selon la distance à laquelle on veut que le lecteur puisse détecter une étiquette et dialoguer avec elle. Pour ces fréquences et ces puissances, l'antenne du lecteur est en général une antenne inductive comprenant une boucle conductrice ou un bobinage conducteur, de préférence monté dans un circuit résonant à la fréquence voulue pour les signaux électromagnétiques. L'antenne de l'étiquette RFID est aussi de ce type, les interactions entre les deux antennes étant décrites par des équations de couplage inductif. La boucle conductrice est associée à des éléments capacitifs pour pouvoir se comporter comme un circuit résonant, et éventuellement associée aussi à des éléments résistifs pour limiter le coefficient de surtension à la résonance. Le courant dans la boucle conductrice engendre le champ électromagnétique auquel est soumise l'étiquette si elle est assez proche.

Le signal haute fréquence produit par le générateur du lecteur est essentiellement un signal périodique mono-fréquence, modulé en amplitude ou en phase pour fournir de l'information ou une commande à une ou plusieurs étiquettes présentes dans le voisinage du lecteur.

Pour réaliser l'étage de sortie du générateur de haute fréquence, on a déjà proposé d'utiliser des circuits inspirés des amplificateurs fonctionnant en classe D. Ces amplificateurs permettent en effet d'atteindre des rendements beaucoup plus élevés que des amplificateurs linéaires fonctionnant en classe A ou des amplificateurs moins linéaires fonctionnant en classe B, AB ou C. Un amplificateur de classe D fonctionne avec des composants actifs (transistors) commandés en tout ou rien entre un état passant et un état bloqué à une fréquence dite fréquence de découpage ; dans l'état passant un courant circule vers une charge de sortie, dans l'état bloqué il est interrompu. Le niveau d'amplification est déterminé par le rapport cyclique du temps de conduction à chaque période de la fréquence de découpage. Le signal d'entrée de l'étage de puissance est donc un signal modulé en largeur d'impulsion à la fréquence de découpage. Un filtrage passe-bas (pouvant faire partie de la charge de sortie) élimine la fréquence de découpage à la sortie pour ne conserver que le signal d'entrée amplifié.

Pour un étage de sortie de générateur haute fréquence, on peut fonctionner sur le principe d'un amplificateur en classe D mais sans éliminer la fréquence de découpage à la sortie, afin que la sortie de l'étage soit justement un signal de puissance (modulé ou non modulé) à la fréquence de découpage.

On a donc déjà proposé des étages de sortie de générateurs haute fréquence comprenant deux interrupteurs, qui sont des transistors fonctionnant en tout ou rien, actionnés à la haute fréquence souhaitée de manière à être conducteurs successivement et non simultanément, reliés à une source d'alimentation par des enroulements inductifs qui reçoivent des courants de sens périodiquement inversé. Ces enroulements sont couplés à d'autres enroulements connectés à une charge de sortie. La charge reçoit un courant alternatif de haute fréquence.

Parmi les contraintes de réalisation de ces étages de sortie, il y a le fait qu'on souhaite de préférence utiliser comme interrupteurs des transistors de même type plutôt que des transistors de type complémentaires, par exemple deux transistors NPN ou deux transistors NMOS mais pas un transistor NPN et un transistor PNP, ou un transistor NMOS et un transistor PMOS. La raison en est qu'il est souhaitable que les transistors aient les mêmes caractéristiques ; or, il est difficile d'obtenir des caractéristiques très semblables, en termes d'impédance ou de temps de rétablissement au moment du blocage, si les transistors ne sont pas de même type. De plus, les schémas électriques sont plus complexes si on utilise des transistors de types différents, en particulier pour les fonctions de commande de ceux-ci, surtout si on doit fonctionner avec une tension d'alimentation variable, ce qui est parfois nécessaire pour assurer une puissance de sortie variable.

Des étages de sortie de générateur haute fréquence utilisant des transistors de même type commandés en tout ou rien à la haute fréquence souhaitée ont déjà été proposés. Ils peuvent utiliser un transformateur à point milieu comme c'est le cas dans la publication de brevet US2003/0179044. Mais un transformateur à point milieu est coûteux car ses caractéristiques doivent impérativement être adaptées à une application donnée et ainsi un tel composant n'est pas facilement disponible dans le commerce.

D'autres propositions ont été faites sur ces principes, par exemple dans les brevets US 4647867, US5726603, US3714597, avec des structures relativement complexes.

La littérature technique décrit également divers circuits d'amplification haute fréquence en classe D, et notamment :
- M. Seo, J. Jeon, I. Jung, Y. Yang "A 13,56 MHz high-efficiency current mode class-D amplifier using a transmission line transformer and harmonic filter". Proceedings of the Asia-Pacific Microwave Conference 2011 ;
- F.H. Raab Switching transients in class-D RF power amplifiers, dans HF radio systems and techniques, 7-10 juillet 1997, conference publication N°411, IEEE, 1997 ;
- Hermann Schreiber, 350 schémas HF de 10kHz à 1 GHz, page 267, Editions Radio 1990.

Tous ces schémas utilisent des inductances dites inductances de mode commun composées de deux enroulements bobinés autour d'un même noyau magnétique. Certains des schémas utilisent deux inductances de mode commun associées en balun de Guanella (on explicitera plus loin ce mode d'association). Ils ont des inconvénients et notamment le fait qu'une composante de courant continu de valeur importante peut circuler dans chaque inductance de mode commun, risquant de saturer les noyaux magnétiques. De plus ces schémas ne permettent pas d'ajuster une valeur d'impédance interne de l'étage de sortie du générateur, alors qu'il est parfois souhaitable de pouvoir choisir la valeur d'impédance interne pour l'adapter à la charge située en aval du générateur.

L'invention a pour but de proposer un nouveau schéma d'étage de sortie d'un générateur haute fréquence, particulièrement simple et efficace et qui permet de choisir la valeur de l'impédance interne de l'étage.

Pour cela, on propose un générateur haute fréquence comportant un étage de puissance fonctionnant en classe D et comportant une source d'alimentation en tension et une masse commune, un premier et un deuxième interrupteurs reliés à la masse commune et commandés respectivement par deux signaux de commande pour être mis en conduction périodiquement et non simultanément à une fréquence F, et deux inductances de mode commun couplées en balun de Guanella, comprenant pour la première inductance de mode commun une première et une deuxième lignes inductives à fort couplage mutuel ayant chacune une entrée et une sortie, et pour la deuxième inductance de mode commun une troisième et une quatrième lignes inductives ayant chacune une entrée et une sortie, caractérisé en ce que le premier interrupteur est relié à l'entrée de la première ligne inductive mais pas de la deuxième ligne et le deuxième interrupteur est relié à l'entrée de la quatrième ligne inductive mais pas de la troisième ligne, la sortie de la première ligne inductive est reliée à la sortie de l'étage de puissance, la sortie de la quatrième ligne inductive est reliée à une impédance interne, les entrées des deuxième et troisième lignes inductives sont reliées à la source de tension d'alimentation, la sortie de la troisième ligne inductive est reliée à la sortie de la première ligne inductive.

La sortie de la deuxième ligne inductive est reliée à l'impédance interne ou éventuellement à une autre impédance interne. En pratique elle est de préférence reliée à la sortie de la quatrième ligne inductive, donc à la même impédance interne.

D'une telle structure, il résulte que dans une phase de conduction du premier interrupteur, un courant peut circuler dans la première ligne inductive de la sortie de l'étage de puissance vers la masse, induisant un courant opposé dans la deuxième ligne inductive de la source d'alimentation vers l'impédance interne, mais sans incidence sur les troisième et quatrième lignes inductives. Dans une phase de conduction du deuxième interrupteur, c'est l'inverse qui se passe : un courant peut circuler dans la quatrième ligne inductive de l'impédance interne vers la masse commune, induisant un courant opposé dans la troisième ligne de la source d'alimentation vers la sortie de l'étage de puissance, sans incidence sur les première et deuxième lignes. Les courants s'inversent dans la charge placée en sortie de l'étage de puissance et dans l'impédance interne entre la phase de conduction du premier interrupteur et la phase de conduction du deuxième interrupteur.

On a constaté que si la structure croisée des deux inductances de mode commun était inversée, les entrées et les sorties des lignes inductives étant purement et simplement inversées, les courants dans les lignes inductives ne se compenseraient pas et une composante de courant continu de valeur importante circulerait dans chaque inductance de mode commun, risquant de saturer les noyaux magnétiques lorsque les inductances de mode commun sont réalisées par deux enroulements bobinés autour d'un même noyau magnétique. La structure selon l'invention dans laquelle chaque interrupteur n'est relié qu'à une ligne inductive évite cet inconvénient.

Les interrupteurs sont de préférence des transistors de même type et sont identiques, que ce soient des transistors bipolaires ou des transistors MOS ou des transistors à effet de champ JFET.

Les inductances de mode commun sont de préférence constituées chacune par deux conducteurs juxtaposés bobinés dans le même sens sur un noyau magnétique. Ces deux conducteurs constituent les deux lignes inductives de l'inductance de mode commun. De manière générale, un grand choix d'inductances de mode commun est disponible dans le commerce, permettant ainsi de disposer de composants de coût réduit. Ces inductances sont caractérisées en premier lieu par une valeur d'inductance en mode commun, et cette valeur n'est pas critique pour le montage. A la fréquence de 13,56 MHz, elle peut être typiquement de quelques microhenrys à plus de 10 microhenrys, donnant une impédance de plusieurs centaines d'ohms à cette fréquence.

Le point commun d'entrée des deuxième et troisième lignes inductives, relié à la source d'alimentation, peut être relié à une masse par une capacité de découplage pour éviter de perturber l'alimentation par des tensions ou courants transitoires venant des commutations de courant dans les lignes inductives.

De préférence, une capacité est placée en série entre le point commun des sorties des première et troisième lignes inductives et la sortie de l'étage de puissance. Une autre capacité est placée en série entre le point commun des sorties des deuxième et quatrième lignes inductives et l'impédance interne. Ces capacités servent à opérer un découplage entre les circuits en aval des sorties des lignes inductives (sortie de l'étage de puissance et impédance interne) et la source d'alimentation en tension.

De préférence également, un filtre passe-bande est placé entre la sortie de l'étage de puissance et la charge alimentée par le générateur. Ce filtre laisse passer la fréquence F d'actionnement des interrupteurs et élimine les harmoniques de cette fréquence, harmoniques résultant de la forme relativement carrée des courants engendrés dans les lignes inductives lors de la commutation périodique.

Dans une réalisation de l'invention, on prévoit que le générateur comporte au moins deux ensembles d'interrupteurs et d'inductances de mode commun montées en balun de Guanella, chaque ensemble formant un étage de puissance élémentaire selon la structure décrite précédemment. Les sorties des différents étages de puissance élémentaires sont connectées à une sortie unique du générateur. Dans un mode particulier de réalisation, une résistance interne unique est utilisée pour les étages de puissance élémentaires. Les sources d'alimentation en tension des étages de puissance élémentaires sont de valeur égale ou différente. Les signaux de commande des interrupteurs des différents ensembles sont soit identiques (et dans ce cas, on obtient dans la charge connectée à la sortie du générateur un courant deux fois plus important pour un même courant dans chacun des interrupteurs), soit différents et dans ce cas on peut modeler la forme du courant dans la charge pour lui donner une allure générale plus sinusoïdale que carrée et ainsi réduire les harmoniques. Le rapport cyclique de conduction des interrupteurs d'un deuxième couple d'interrupteurs est alors inférieur au rapport cyclique de conduction du premier ensemble ; les durées de conduction des interrupteurs du deuxième couple sont situées pendant les durées de conduction des interrupteurs correspondants du premier couple.

D'autres caractéristiques et avantages de l'invention apparaîtront à la lecture de la description détaillée qui suit et qui est faite en référence aux dessins annexés dans lesquels :
- la figure 1 représente un schéma général de connexion d'un générateur de haute fréquence à une antenne inductive dans une application de lecteur d'étiquette RFID ;
- la figure 2 représente un schéma d'inductances de mode commun associées en balun de Guanella ;
- la figure 3 représente un schéma du générateur de haute fréquence selon l'invention ;
- la figure 4 représente un schéma avec un filtre passe-bande en sortie du générateur ;
- la figure 5 représente un schéma avec deux structures élémentaires d'étage de puissance en parallèle ;
- la figure 6 représente l'allure du courant de sortie pour une première configuration des tensions de commande des transistors ;
- la figure 7 représente l'allure du courant de sortie pour une autre configuration des tensions de commande des transistors.

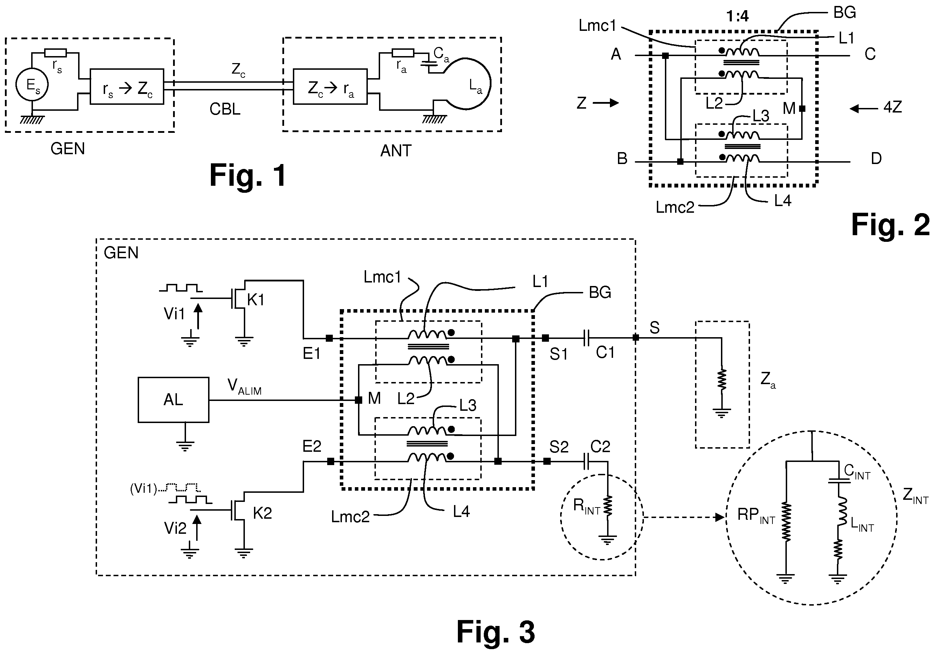

Sur la figure 1, on a représenté la constitution de principe de la partie émission d'une station de base dans un système de communication à haute fréquence. On considère dans la suite qu'il s'agit d'un système d'identification d'étiquettes RFID où un échange de données a lieu entre la station de base et des objets porteurs d'étiquettes. Mais l'invention n'est pas limitée à cette application : l'invention peut même s'appliquer en dehors de tout système d'échange de données, par exemple pour une télé-alimentation inductive de circuits électroniques dépourvus d'alimentation propre, ou pour recharger par voie inductive une batterie rechargeable d'un système autonome.

La partie émission de la station de base comprend un générateur de haute fréquence GEN et une antenne inductive ANT. Le générateur est symbolisé par une source de tension Eₛ fournissant un signal alternatif à une haute fréquence F, ce signal pouvant être modulé, par exemple en amplitude ou en phase ; cette source de tension est accompagnée d'une impédance en série rₛ représentant l'impédance interne du générateur.

L'antenne est principalement un bobinage inductif, ou une simple boucle inductive, d'inductance Lₐ, produisant un champ électromagnétique à haute fréquence lorsqu'elle est parcourue par un courant à haute fréquence. L'antenne comprend de préférence une capacité Cₐ en série avec la boucle, de valeur calculée pour constituer un circuit résonant à la haute fréquence F. Une résistance rₐ en série avec l'inductance Lₐ et la capacité Cₐ représente symboliquement l'impédance interne de l'antenne ; sa valeur est choisie pour définir le facteur de qualité Q qu'on veut donner à l'antenne (Q₀ = L_{ω}/Rₐ) ou à l'ensemble antenne + générateur (Q = Lₐω/(rₐ + rₛ), ω étant la pulsation 2πF. Ce facteur de qualité ne doit pas être trop élevé si on veut une bande passante suffisante. On peut le choisir inférieur ou égal à 100. La puissance totale consommée par le générateur et l'antenne est P = (rₐ + rₛ) Iₐ² si Iₐ est le courant consommé par l'antenne. Les formules pour le facteur de qualité Q et la puissance P sont données pour le cas simplifié où le générateur est directement connecté à l'antenne. Ces formules montrent que la résistance interne rₛ participe au dimensionnement de l'antenne, bien que faisant partie du générateur. La partie de la puissance P dissipée dans le générateur n'est donc pas inutile.

Le générateur est relié à l'antenne ANT par un câble CBL, par exemple un câble coaxial. L'impédance caractéristique de ce câble est Zc. On prévoit de préférence dans le générateur GEN un circuit d'adaptation d'impédance pour adapter l'impédance rₛ de la source de tension à l'impédance caractéristique Z_{C} du câble ; un autre circuit d'adaptation d'impédance est prévu dans l'antenne pour adapter l'impédance rₐ de l'antenne à l'impédance caractéristique Z_{C} du câble. Cette adaptation d'impédance a pour but d'optimiser la transmission de puissance du générateur à l'antenne.

La figure 2 rappelle quelle est la constitution d'un balun de Guanella, désigné par BG sur la figure : il est constitué de deux impédances de mode commun ayant chacune deux entrées et deux sorties, les entrées et sorties étant connectées d'une manière particulière. Une inductance de mode commun est constituée de deux lignes inductives placées côte à côte avec un fort couplage inductif mutuel, idéalement un couplage égal à 1 ; c'est-à-dire qu'une tension alternative aux bornes d'une des lignes engendre une tension de même valeur dans l'autre, ou qu'un courant alternatif dans l'une des lignes engendre un courant opposé et de même valeur dans l'autre.

La première inductance de mode commun est désignée par Lmc1 ; la deuxième est désignée par Lmc2. La première inductance de mode commun comprend deux lignes inductives L1 et L2 ; la deuxième inductance de mode commun comprend deux lignes inductives L3 et L4.

Le balun de Guanella comporte quatre bornes A, B d'un côté, C, D de l'autre. La borne A est reliée à une première extrémité des lignes inductives L1 et L3 ; la borne B est reliée à une première extrémité des lignes inductives L2 et L4 ; la borne C est reliée à l'autre extrémité de la ligne L1 ; la borne D est reliée à l'autre extrémité de la ligne L4 ; les autres extrémités des lignes L2 et L3 sont reliées entre elles et constituent un point milieu M qui peut constituer une borne supplémentaire du balun de Guanella. Enfin, si les lignes inductives sont constituées par des bobinages, par exemple par des bobinages autour de noyaux de ferrite, le sens des enroulements est le même pour les deux bobinages d'une inductance de mode commun lorsqu'on va de la première extrémité d'une ligne à la deuxième extrémité, ce qui est représenté classiquement par un point situé du même côté sur les deux enroulements.

Le balun de Guanella a la propriété de présenter une impédance vue des extrémités C et D quadruple de l'impédance vue des extrémités A, B et on a coutume d'appeler balun de Guanella 1:4 le balun représenté sur la figure 2 lorsqu'on considère la conversion d'impédance du côté A, B vers le côté C,D. On l'appellerait balun de Guanella 4:1 si on considérait la conversion d'impédance à partir du côté C, D vers le côté A, B.

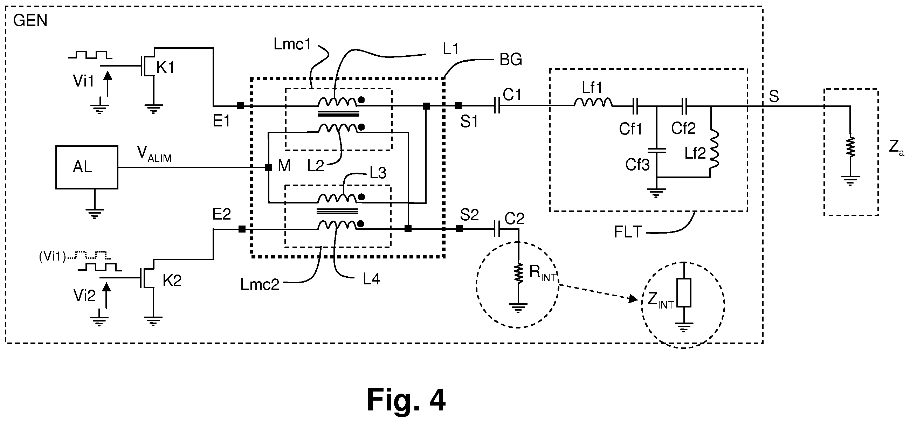

La figure 3 représente le principe du générateur de haute fréquence selon l'invention, utilisant un balun de Guanella. La charge connectée en sortie du générateur est représentée par une simple impédance Zₐ, mais cette charge est en pratique l'ensemble du câble CBL et de l'antenne ANT représentés à la figure 1, à quoi il faut rajouter éventuellement un filtre passe-bande (décrit plus loin en référence à la figure 4), un circuit d'adaptation d'impédance (pouvant être inclus dans le filtre passe-bande).

Le générateur comprend deux interrupteurs identiques K1, et K2, qui sont des transistors bipolaires ou des transistors à effet de champ et notamment des transistors à effet de champ à grille isolée. Les transistors sont de même type, de préférence de type NPN si ce sont des transistors bipolaires et des transistors à canal N si ce sont des transistors à effet de champ. Les interrupteurs sont reliés d'un côté à une masse commune et de l'autre chacun à une borne respective du balun de Guanella. Chacun est affecté à une seule ligne inductive d'une inductance de mode commun respective du balun de Guanella. Ils sont commandés par des signaux carrés Vi1 et Vi2, à la haute fréquence désirée F et ils fonctionnent en tout ou rien : les transistors sont soit bloqués soit conducteurs. Les transistors ne sont pas conducteurs simultanément. Dans le cas le plus simple, ils fonctionnent en opposition de phase, c'est-à-dire que l'un est conducteur pendant que l'autre est bloqué et réciproquement. Dans un autre cas, le rapport cyclique de conduction (temps de conduction sur une période) est inférieur à 50% : les transistors sont conducteurs pendant moins d'une demi-période de la fréquence F, ils peuvent être bloqués simultanément, mais pas conducteurs simultanément. La modulation du rapport cyclique permet d'agir sur la puissance de sortie du générateur, la puissance étant maximale lorsque le rapport cyclique est de 50%. Dans tous les cas, les tensions Vi1 et Vi2 sont en opposition de phase, c'est-à-dire que les durées de mise en conduction d'un interrupteur sont déphasées de 180° à la fréquence F par rapport aux durées de mise en conduction de l'autre interrupteur.

Le balun de Guanella est celui qui est représenté à la figure 2, avec deux inductances de mode commun Lmc1 et Lmc2 comprenant chacune deux lignes inductives fortement couplées, respectivement L1, L2 et L3, L4, qui sont de préférence des bobinages entourant un noyau magnétique (ferrite). Le couplage mutuel des deux lignes est idéalement égal à 1. Le balun est monté en balun de Guanella 4:1 de la gauche vers la droite de la figure 3 (donc l'inverse de ce qui est représenté sur la figure 2), l'impédance du balun vue de l'entrée à gauche étant quatre fois supérieure à l'impédance vue de la sortie à droite.

Le premier interrupteur K1 est relié à une première borne d'entrée E1 du balun, borne à laquelle est reliée une première extrémité ou l'entrée d'une seule ligne inductive, cette ligne étant la première ligne inductive L1 de la première inductance de mode commun Lmc1 ; mais le premier interrupteur n'est pas relié à la deuxième ligne inductive L2 de cette première inductance de mode commun ni aux lignes inductives L3 et L4 de l'autre inductance de mode commun Lmc2 ; la deuxième extrémité ou sortie de la ligne L1 est reliée à une sortie S1 du balun.

Le deuxième interrupteur K2 est relié à une borne d'entrée E2 du balun, borne à laquelle est reliée une première extrémité ou l'entrée d'une seule ligne inductive, cette ligne étant la quatrième ligne inductive L4 de la deuxième inductance de mode commun Lmc2 ; mais le deuxième interrupteur n'est pas relié à la troisième ligne inductive L3 appartenant à cette deuxième inductance de mode commun ni aux lignes inductives L1 et L2 de l'autre inductance de mode commun Lmc1 ; la deuxième extrémité ou sortie de la ligne L4 est reliée à une sortie S2 du balun, elle-même reliée à travers une capacité de découplage C2 à une résistance interne R_{INT}.

Les premières extrémités ou entrées des deuxième et troisième lignes L2 et L3 sont réunies en un point milieu M. Ce point milieu est relié à une source d'alimentation en tension AL fournissant une tension d'alimentation V_{ALIM} fixe ou variable. Une variation de la tension d'alimentation permet de faire varier la puissance de sortie du générateur.

La deuxième extrémité ou sortie de la deuxième ligne L2 est reliée à la sortie S2 (reliée également à la deuxième extrémité ou sortie de la ligne L4), mais elle pourrait en variante être reliée à une autre résistance interne différente de R_{INT} et reliée à la masse commune comme elle. La deuxième extrémité ou sortie de la troisième ligne L3 est reliée à la sortie S1 (reliée également à la deuxième extrémité ou sortie de la ligne L1).

La sortie S du générateur est reliée à la sortie S1 du balun à travers une capacité de découplage en série C1. Cette capacité évite la circulation d'une composante de courant continu dans la charge Zₐ alimentée par le générateur.

La sortie S2 du balun est reliée à travers une capacité de découplage C2 à une résistance interne R_{INT} dont la fonction est d'imposer au générateur une impédance interne de source déterminée. Un ajustement de la résistance peut être fait en fonction de l'application pour adapter l'impédance du générateur à l'impédance de l'antenne inductive, en tenant compte de l'impédance du câble éventuellement présent entre le générateur et l'antenne.

La résistance interne R_{INT} peut éventuellement être remplacée par une impédance complexe Z_{INT} comme cela est figuré dans un cercle pointillé sur la figure 3. L'impédance Z_{INT} est essentiellement constituée par un circuit résonant série formé d'une capacité C_{INT} en série avec une inductance L_{INT} et une résistance R_{INT} (de même valeur que dans le cas où elle est toute seule) ; le circuit est résonant à la fréquence de travail F du générateur. Une résistance RP_{INT} peut être placée en parallèle avec l'ensemble série ; son rôle est de fixer une valeur d'impédance maximale à Z_{INT} en dehors de la fréquence de résonance.

Cette solution permet d'effectuer un pré-filtrage du signal sur la sortie S pour pouvoir y connecter directement une charge Zₐ, éventuellement en complément du filtrage effectué par un filtre comme on le verra à propos de la figure 4.

Une capacité de découplage non représentée peut être prévue entre la sortie de l'alimentation AL et la masse.

Dans une application à un système de communication avec des étiquettes RFID portées par des objets mobiles, le générateur haute fréquence comporte des moyens de modification de la puissance fournie à la charge pour modifier le niveau du champ magnétique produit par l'antenne en fonction de la distance de l'étiquette avec laquelle une communication a été établie. Ces moyens agissent sur le niveau de la tension d'alimentation V_{ALIM} fournie par l'alimentation en tension AL.

Toujours dans cette application, on prévoit que l'échange d'informations a lieu par modulation d'amplitude ou de phase de la fréquence émise. Pour la modulation d'amplitude, on peut agir soit sur la tension d'alimentation V_{ALIM} soit sur le rapport cyclique de conduction des interrupteurs K1 et K2. Pour la modulation de phase, on effectue des sauts de phase en changeant la phase des créneaux de tension Vi1 et Vi2 appliqués comme signaux de commande aux interrupteurs K1 et K2.

On notera que la modification de puissance fournie à la charge par action sur la tension d'alimentation V_{ALIM} permet une grande plage de variation de puissance (par exemple une dynamique d'un facteur supérieur à 100) de manière très graduelle (par pas inférieur à 1% de la pleine échelle).

Le schéma de la figure 3 fonctionne de la manière suivante : lors de la mise en conduction du premier interrupteur K1, un courant de valeur I_{S} tend à circuler dans la ligne inductive L1 en direction du transistor K1. Le fort couplage des lignes L1 et L2 engendre un courant identique I_{S} dans la ligne L2, dans le sens inverse, fourni par l'alimentation. L'interrupteur K2 est bloqué, le courant dans la ligne L4 est nul. Le fort couplage des lignes L3 et L4 alors que cette dernière n'est pas parcourue par un courant fait qu'aucun courant ne peut circuler dans la ligne L3. En conséquence le courant I_{S} circulant dans la ligne inductive L1 passe nécessairement et entièrement dans la charge Za (de la masse à la sortie S1) : de même, le courant I_{S} circulant dans la ligne L2 passe nécessairement et entièrement dans la résistance interne R_{INT} (de la sortie S2 à la masse).

Inversement, lors de la mise en conduction du second interrupteur K2, un courant de valeur Is tend à circuler dans la ligne inductive L4 en direction du transistor K2. Le fort couplage des lignes L3 et L4 engendre un courant identique Is dans la ligne L3, dans le sens inverse, fourni par l'alimentation. L'interrupteur K1 est bloqué, le courant dans la ligne L1 est nul. Le fort couplage des lignes L2 et L1 alors que cette dernière n'est pas parcourue par un courant fait qu'aucun courant ne peut circuler dans la ligne L2. En conséquence le courant Is circulant dans la ligne inductive L3 passe nécessairement et entièrement dans la charge Za (de la sortie S1 à la masse), de même le courant Is circulant dans la ligne L4 passe nécessairement et entièrement dans la résistance interne Rint (de la masse à la sortie S2).

Il circule donc dans la charge, de la sortie S1 vers la masse, alternativement un courant de valeur Iₛ et un courant opposé -Iₛ, à la fréquence de commutations des interrupteurs. C'est le cas aussi dans la résistance interne R_{INT}.

Le générateur fournit donc à la charge un courant alternatif I_{S} à fréquence F. Si la charge est une antenne inductive, elle produit un champ électromagnétique à fréquence F, éventuellement modulé en phase ou en amplitude.

Comme le courant de sortie a une forme relativement carrée en raison de la commutation en tout ou rien des interrupteurs, il est préférable d'interposer entre la sortie S1 du balun de Guanella et la charge un filtre passe-bande capable d'éliminer les harmoniques et sous-harmoniques de la fréquence F. Le filtre peut d'ailleurs être calculé pour réaliser en même temps une adaptation d'impédance entre l'impédance interne du générateur et une impédance de référence, par exemple l'impédance caractéristique du câble de liaison avec l'antenne lorsque le générateur alimente une antenne.

La figure 4 représente le générateur avec un filtre passe-bande incorporé au générateur, en amont de la sortie S et en aval de la capacité de découplage C1. Ce filtre FLT est ici composé d'un ensemble de trois capacités en T, Cf1, Cf2, Cf3, une inductance Lf1 en série en amont du T et une inductance Lf2 en parallèle avec la sortie du T.

On remarquera que la résistance interne R_{INT} dissipe de la puissance puisqu'elle supporte un courant identique à celui qui circule dans la charge. Mais cette résistance n'est pas nécessairement placée sur le même circuit électronique que les autres éléments du générateur. La chaleur qu'elle dissipe peut donc être éloignée des éléments sensibles du circuit. De plus, elle est un composant passif qui peut supporter de plus hautes températures que les éléments actifs du générateur.

Le montage est tolérant à une désadaptation même importante entre l'impédance du générateur et celle de la charge. Il continue à fonctionner même avec un rapport d'onde stationnaire (ROS) égal à 2.

Comme à la figure 3, la résistance interne R_{INT} peut être remplacée par une impédance complexe Z_{INT} comprenant un circuit résonant série.

L'inductance de mode commun présente de préférence une valeur d'inductance assez élevée, représentant une impédance supérieure aux impédances présentes dans le reste du circuit (impédances résiduelles des transistors à l'état passant, de la résistance interne R_{INT} et de l'impédance de charge ramenée au point S1, notamment), pour les hautes fréquences concernées. Par exemple, une inductance de mode commun de 10 microhenrys représente une impédance de 900 ohms à 13,56 MHz (fréquence standard pour des communications RFID). Cette valeur est à comparer aux impédances de quelques ohms de la résistance interne R_{INT} et de l'impédance de charge ramenée au point S1, du même ordre de grandeur.

L'inductance mutuelle résiduelle L_{md} des inductances de mode commun est de préférence la plus faible possible. Elle n'est pas nulle si le coefficient de couplage mutuel des deux lignes inductives est k légèrement inférieur à 1 et elle est égale à l'inductance de mode commun L_{mc} multipliée par 1-k². Elle engendre des surtensions aux commutations des transistors. Le coefficient de couplage k est de préférence supérieur à 0,98 pour minimiser ces surtensions.

Le filtre FLT représenté à la figure 4 peut avoir les caractéristiques suivantes pour une fréquence autour de 13,56 MHz et pour une adaptation d'impédance de 12 ohms vers 50 ohms :
Lf1 = 470 nanohenrys
Cf1 = 330 picofarads
Cf2 = 1,220 nanofarads
Cf3 = 1,220 nanofarads
Lf2 = 220 nanohenrys

Un autre jeu de valeurs possible pour une adaptation d'impédance de 8 ohms vers 50 ohms et en gardant les mêmes valeurs d'inductance serait : 330 pF, 1,047 nF et 1,56 nF pour les capacités Cf1, Cf2, Cf3 respectivement.

Les tensions de commande Vi1 et Vi2 appliquées aux transistors interrupteurs pour les faire passer de l'état bloqué à l'état passant sont de préférence produites par une simple bascule D à deux sorties complémentaires, recevant un signal d'horloge à une fréquence 2F et fournissant deux signaux complémentaires à fréquence F. Si une modulation de largeur d'impulsion doit avoir lieu, notamment pour assurer une transmission d'information, on utilisera bien entendu un schéma de circuit de modulation de largeur plus complexe qu'une simple bascule D.

Pour des transistors MOSFET nécessitant des courants de grille plus élevés que ceux que peuvent délivrer les bascules ou autres portes logiques, des circuits spécialisés (drivers de MOS) sont utilisés ; ils sont intercalés entre les portes logiques et les grilles de transistors MOS.

La tension d'alimentation V_{ALIM} est de préférence une tension variable de quelques volts (par exemple 2 volts) à plusieurs dizaines de volts, (par exemple 30 volts), pour ajuster la puissance d'émission dans une gamme pouvant aller de 100 milliwatts à 15 watts.

La résistance interne R_{INT} peut être de 5 ohms environ dans cet exemple de réalisation.

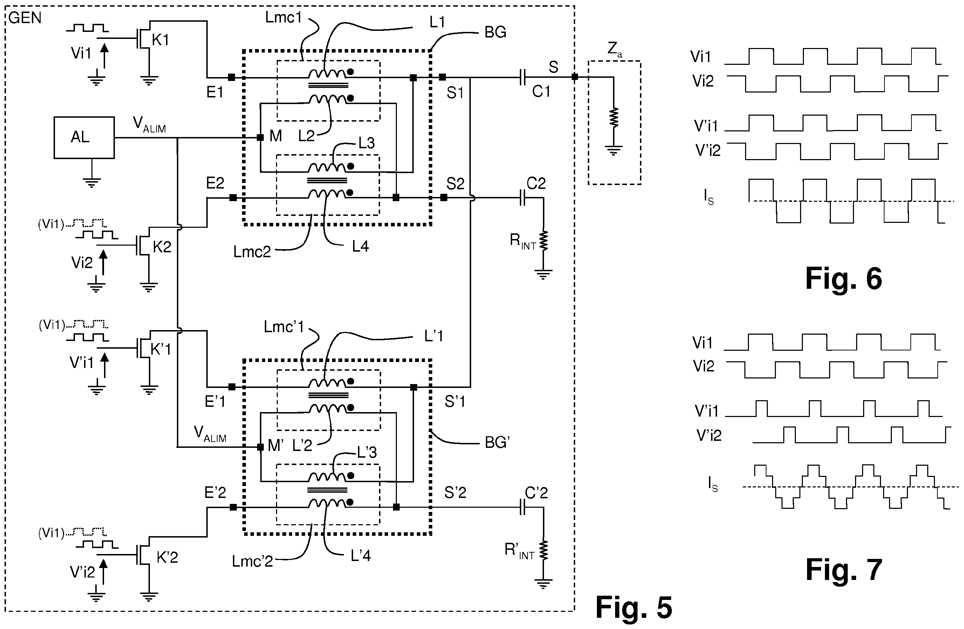

Dans une variante de réalisation représentée à la figure 5, on prévoit qu'il y a plusieurs baluns de Guanella (deux sur la figure 5) et deux interrupteurs respectifs associés à chacun des baluns.

Le premier balun de la figure 5 ainsi que tous les éléments de circuit associés à ce balun sont disposés exactement comme à la figure 3 et portent les mêmes références. Le deuxième balun et les éléments associés portent les mêmes références affectées de l'indice "prime" : BG', K'1, K'2, Lmc'1, Lmc'2, L'1, L'2, L'3, L'4, E'1, E'2, S'1, S'2. La sortie S'1 est reliée à la sortie S1 et de là par la capacité de découplage C1 à la sortie S du générateur. Le filtre FLT n'est pas représenté sur cette figure mais est de préférence présent.

La sortie S'2 peut être reliée à la sortie S2, ou peut être reliée séparément à une autre résistance interne R'_{INT} à travers une capacité de découplage C'2 différente de C2.

Dans la variante de réalisation représentée à la figure 5, la tension d'alimentation est commune aux deux ensembles de structure similaire à la figure 3. Dans un autre mode de réalisation, les tensions d'alimentation des deux ensembles sont deux tensions différentes V_{ALIM} et V'_{ALIM}.

Les tensions de commande V'i1 et V'i2 appliquées aux interrupteurs K'1 et K'2 respectent les mêmes conditions que les tensions de commande Vi1 et Vi2 : périodicité de la conduction à la même fréquence F, même durée de conduction pour K'1 et K'2, décalage d'une demi-période entre les durées de conduction des deux interrupteurs, et absence de conduction simultanée des deux interrupteurs.

Dans un premier exemple, représenté à la figure 6, les tensions de commande Vi'1 et Vi'2 sont identiques respectivement aux tensions Vi1 et Vi2. On aboutit alors à un doublement du courant Iₛ dans la charge pour un courant donné circulant dans chaque interrupteur. En effet, la charge voit la somme des courants passant dans les interrupteurs K1 et K'1 puis la somme des courants passant dans les interrupteurs K2 et K'2.

Dans un autre exemple de fonctionnement, représenté à la figure 7, on fait circuler un courant dans le deuxième ensemble pendant des durées plus courtes que dans le premier ensemble, dans le but de donner une conformation plus sinusoïdale au courant de sortie Iₛ. Le rapport cyclique de mise en conduction des interrupteurs K'1 et K'2 est donc plus faible que celui des interrupteurs K1 et K2. La conduction des interrupteurs K'1 a lieu cependant pendant la conduction des interrupteurs K1, et il en est de même pour K'2 et K2. Dans l'exemple représenté la durée de conduction de l'interrupteur K'1 est située au milieu de la durée de conduction de l'interrupteur K1. Le résultat est la forme de courant Iₛ représentée à la figure 7, ayant une allure générale plus sinusoïdale, facilitant le filtrage ultérieur. Les formes de courant I_{S} représentées sur les figures 6 et 7 sont simplifiées pour le besoin des explications, mais dans la réalité les éléments de circuit assurent intrinsèquement un certain filtrage qui fait que les formes ne sont pas aussi carrées que celles qui sont représentées.

## Revendications

1. Générateur haute fréquence comportant un étage de puissance fonctionnant en classe D et comportant une source d'alimentation en tension (AL) et une masse commune, un premier et un deuxième interrupteurs (K1, K2) reliés à la masse commune et commandés respectivement par deux signaux de commande pour être mis en conduction périodiquement et non simultanément à une fréquence F, et deux inductances de mode commun (Lmc1, Lmc2) couplées en balun de Guanella, comprenant pour la première inductance de mode commun une première et une deuxième lignes inductives (L1, L2) à fort couplage mutuel ayant chacune une entrée et une sortie, et pour la deuxième inductance de mode commun une troisième et une quatrième lignes inductives (L3, L4) ayant chacune une entrée et une sortie, **caractérisé en ce que** le premier interrupteur (K1) est relié à l'entrée de la première ligne inductive (L1) mais pas aux deuxième, troisième et quatrième lignes inductives (L2, L3, L4) et le deuxième interrupteur (K2) est relié à l'entrée de la quatrième ligne inductive (L4) mais pas aux première, deuxième, et troisième lignes (L1, L2, L3), la sortie de la première ligne inductive (L1) est reliée à une sortie (S) de l'étage de puissance du générateur, la sortie de la quatrième ligne inductive est reliée à une impédance interne (Z_{INT}), les entrées des deuxième et troisième lignes inductives (L2, L3) sont reliées à la source de tension d'alimentation, la sortie de la troisième ligne inductive est reliée à la sortie de la première ligne inductive et la sortie de la deuxième ligne inductive est reliée à l'impédance interne ou à une autre impédance interne.

2. Générateur selon la revendication 1, **caractérisé en ce que** la sortie de la deuxième ligne inductive est reliée à la sortie de la quatrième ligne inductive.

3. Générateur haute fréquence selon l'une des revendications 1 et 2, **caractérisé en ce que** les interrupteurs sont des transistors de même type.

4. Générateur haute fréquence selon l'une des revendications 1 à 3, **caractérisé en ce que** les inductances de mode commun sont constituées chacune par deux conducteurs juxtaposés bobinés dans le même sens sur un noyau magnétique.

5. Générateur haute fréquence selon l'une des revendications 1 à 4, **caractérisé en ce qu'**une capacité (C1) est placée en série entre le point de connexion des sorties de la première et la troisième lignes inductives et la sortie du générateur.

6. Générateur haute fréquence selon la revendication 5, **caractérisé en ce qu'**une autre capacité (C2) est placée en série entre la sortie de la quatrième ligne inductive et l'impédance interne.

7. Générateur haute fréquence selon l'une des revendications 1 à 6, **caractérisé en ce qu'**un filtre passe-bande est placé entre le point de connexion des sorties des première et troisième lignes inductives et la sortie du générateur.

8. Générateur haute fréquence selon l'une des revendications 1 à 7, **caractérisé en ce qu'**il comporte un autre couple d'interrupteurs (K'1, K'2) et un autre couple d'inductances de mode commun (Lmc'1, Lmc'2) constitués et associés entre eux comme le premier couple d'interrupteurs et le premier couple d'inductances de mode commun, la sortie de la première ligne du deuxième couple d'inductances de mode commun étant reliée à la sortie de la première ligne du premier couple.

9. Générateur haute fréquence selon la revendication 8, **caractérisé en ce que** les signaux de commande (Vi'1, Vi'2) du deuxième couple d'interrupteurs sont identiques aux signaux de commande (Vi1, Vi2) du premier couple.

10. Générateur haute fréquence selon la revendication 8, **caractérisé en ce que** le rapport cyclique de conduction des interrupteurs du deuxième couple est inférieur au rapport cyclique de conduction du premier couple, les durées de conduction des interrupteurs du deuxième couple étant situés pendant les durées de conduction des interrupteurs correspondants du premier couple.

## Patentansprüche

1. Hochfrequenzgenerator, der Folgendes umfasst: eine Leistungsstufe, die in der D-Klasse arbeitet und eine Spannungsversorgungsquelle (AL) und eine gemeinsame Masse umfasst, einen ersten und einen zweiten Unterbrecher (K1, K2), die mit der gemeinsamen Masse verbunden sind und jeweils durch zwei Steuersignale gesteuert werden, um periodisch und nicht gleichzeitig mit einer Frequenz F leitend gemacht zu werden, und zwei Gleichtaktinduktanzen (Lmc1, Lmc2), die zu einem Guanella-Balun gekoppelt sind, umfassend für die erste Gleichtaktinduktanz eine erste und eine zweite induktive Leitung (L1, L2) mit starker gegenseitiger Kopplung jeweils mit einem Eingang und einem Ausgang, und für die zweite Gleichtaktinduktanz eine dritte und eine vierte induktive Leitung (L3, L4) jeweils mit einem Eingang und einem Ausgang, **dadurch gekennzeichnet, dass** der erste Unterbrecher (K1) mit dem Eingang der ersten induktiven Leitung (L1), aber nicht mit der zweiten, dritten und vierten induktiven Leitung (L2, L3, L4) verbunden ist, und der zweite Unterbrecher (K2) mit dem Eingang der vierten induktiven Leitung (L4), aber nicht mit der ersten, zweiten und dritten Leitung (L1, L2, L3) verbunden ist, wobei der Ausgang der ersten induktiven Leitung (L1) mit einem Ausgang (S) der Leistungsstufe des Generators verbunden ist, der Ausgang der vierten induktiven Leitung mit einer internen Impedanz (Z_{INT}) verbunden ist, wobei die Eingänge der zweiten und dritten induktiven Leitung (L2, L3) mit der Spannungsversorgungsquelle verbunden sind, der Ausgang der dritten induktiven Leitung mit dem Ausgang der ersten induktiven Leitung verbunden ist und der Ausgang der zweiten induktiven Leitung mit der internen Impedanz oder mit einer anderen internen Impedanz verbunden ist.

2. Generator nach Anspruch 1, **dadurch gekennzeichnet, dass** der Ausgang der zweiten induktiven Leitung mit dem Ausgang der vierten induktiven Leitung verbunden ist.

3. Hochfrequenzgenerator nach einem der Ansprüche 1 und 2, **dadurch gekennzeichnet, dass** die Unterbrecher Transistoren desselben Typs sind.

4. Hochfrequenzgenerator nach einem der Ansprüche 1 bis 3, **dadurch gekennzeichnet, dass** die Gleichtaktinduktanzen jeweils von zwei nebeneinander liegenden Leitern gebildet werden, die in derselben Richtung auf einem Magnetkern gewickelt sind.

5. Hochfrequenzgenerator nach einem der Ansprüche 1 bis 4, **dadurch gekennzeichnet, dass** eine Kapazität (C1) in Serie zwischen dem Verbindungspunkt der Ausgänge der ersten und der dritten induktiven Leitung und dem Ausgang des Generators platziert ist.

6. Hochfrequenzgenerator nach Anspruch 5, **dadurch gekennzeichnet, dass** eine andere Kapazität (C2) in Serie zwischen dem Ausgang der vierten induktiven Leitung und der internen Impedanz platziert ist.

7. Hochfrequenzgenerator nach einem der Ansprüche 1 bis 6, **dadurch gekennzeichnet, dass** ein Bandpassfilter zwischen dem Verbindungspunkt der Ausgänge der ersten und dritten induktiven Leitung und dem Ausgang des Generators platziert ist.

8. Hochfrequenzgenerator nach einem der Ansprüche 1 bis 7, **dadurch gekennzeichnet, dass** er ein anderes Unterbrecherpaar (K'1, K'2) und ein anderes Gleichtaktinduktanzpaar (Lmc'1, Lmc'2) umfasst, die miteinander als erstes Unterbrecherpaar und als erstes Gleichtaktinduktanzpaar gebildet werden und assoziiert sind, wobei der Ausgang der ersten Leitung des zweiten Gleichtaktinduktanzpaares mit dem Ausgang der ersten Leitung des ersten Paares verbunden ist.

9. Hochfrequenzgenerator nach Anspruch 8, **dadurch gekennzeichnet, dass** die Steuersignale (Vi'1, Vi'2) des zweiten Unterbrecherpaares mit den Steuersignalen (Vi1, Vi2) des ersten Paares identisch sind.

10. Hochfrequenzgenerator nach Anspruch 8, **dadurch gekennzeichnet, dass** das zyklische Leitungsverhältnis der Unterbrecher des zweiten Paares kleiner ist als das zyklische Leitungsverhältnis des ersten Paares, wobei die Leitungsdauern der Unterbrecher des zweiten Paares innerhalb der Leitungsdauern der Unterbrecher entsprechend dem ersten Paar liegen.

## Claims

1. A high-frequency generator comprising a class D power stage comprising a voltage supply (AL) and a common earth, a first and a second switch (K1, K2) linked to the common earth and respectively controlled by two control signals to be switched on periodically and non-simultaneously at a frequency F, and two common-mode inductors (Lmc1, Lmc2) coupled in a Guanella balun, comprising for the first common-mode inductor a first and a second inductive line (L1, L2) with strong mutual coupling, each having an input and an output, and for the second common-mode inductor a third and a fourth inductive line (L3, L4), each having an input and an output, **characterized in that** the first switch (K1) is linked to the input of the first inductive line (L1) but not to the second, third and fourth inductive lines (L2, L3, L4) and the second switch (K2) is linked to the input of the fourth inductive line (L4) but not to the first, second and third lines (L1, L2, L3), the output of the first inductive line (L1) is linked to an output (S) of the power stage of the generator, the output of the fourth inductive line is linked to an internal impedance (Z_{INT}), the inputs of the second and third inductive lines (L2, L3) are linked to the supply voltage source, the output of the third inductive line is linked to the output of the first inductive line and the output of the second inductive line is linked to the internal impedance or to another internal impedance.

2. The generator as claimed in claim 1, **characterized in that** the output of the second inductive line is linked to the output of the fourth inductive line.

3. The high-frequency generator as claimed in either of claims 1 and 2, **characterized in that** the switches are transistors of the same type.

4. The high-frequency generator as claimed in one of claims 1 to 3, **characterized in that** the common-mode inductors are each formed by two juxtaposed conductors coiled in the same direction on a magnetic core.

5. The high-frequency generator as claimed in one of claims 1 to 4, **characterized in that** a capacitor (C1) is placed in series between the connection point of the outputs of the first and the third inductive lines and the output of the generator.

6. The high-frequency generator as claimed in claim 5, **characterized in that** another capacitor (C2) is placed in series between the output of the fourth inductive line and the internal impedance.

7. The high-frequency generator as claimed in one of claims 1 to 6, **characterized in that** a band-pass filter is placed between the connection point of the outputs of the first and the third inductive lines and the output of the generator.

8. The high-frequency generator as claimed in one of claims 1 to 7, **characterized in that** it comprises another pair of switches (K'1, K'2) and another pair of common-mode inductors (Lmc'1, Lmc'2) formed and associated together in the same way as the first pair of switches and the first pair of common-mode inductors, the output of the first line of the second pair of common-mode inductors being linked to the output of the first line of the first pair.

9. The high-frequency generator as claimed in claim 8, **characterized in that** the control signals (Vi'1, Vi'2) of the second pair of switches are identical to the control signals (Vi1, Vi2) of the first pair.

10. The high-frequency generator as claimed in claim 8, **characterized in that** the conduction duty cycle of the switches of the second pair is smaller than the conduction duty cycle of the first pair, the conduction times of the switches of the second pair being located during the conduction times of the corresponding switches of the first pair.
